# FASCICULE DE BREVET EUROPEEN

(11) **EP 2 836 360 B1**
(45) Date de publication et mention de la délivrance du brevet: **30.09.2020**
(21) Numéro de dépôt: 13727289.4
(22) Date de dépôt: 14.05.2013
(51) Int. Cl.: B32B 17/10, G02B 5/10

(54) **PROCÉDÉ DE MISE EN FORME D'UNE FEUILLE DE MATÉRIAU AYANT UNE FAIBLE RÉSISTANCE À LA TRACTION ET MIROIR COMPORTANT UNE TELLE FEUILLE**
VERFAHREN ZUR UMFORMUNG EINER FOLIE AUS EINEM MATERIAL MIT GERINGER ZUGFESTIGKEIT UND SPIEGEL MIT SOLCH EINER FOLIE
METHOD FOR SHAPING A FILM OF A MATERIAL THAT HAS LOW RESISTANCE TO TRACTION, AND MIRROR COMPRISING SUCH A FILM

(43) Date de publication de la demande: 18.02.2015
(73) Titulaire: Helioclim, 06210 Mandelieu La Napoule (FR)
(72) Inventeur: GODILLOT, Yannick, F-06580 Pegomas (FR); NGHIEM, Marie, F-06400 CANNES (FR); VITUPIER, Yann, F-06250 Mougins (FR); DANIEL, Charles, F-06210 Mandelieu La Napoule (FR); PES, Mickael, Redwood City, CA 94062 (US)
(74) Mandataire: Cornuejols, Georges
(86) Numéro de dépôt international: PCT/FR2013/051053
(87) Numéro de publication internationale: WO 2013/171423

(56) Documents cités:
- WO-A1-2010/115237
- WO-A1-2010/138087
- DE-A1- 3 723 245
- GB-A- 2 042 761
- GB-A- 2 104 444
- US-A- 4 124 277
- US-A- 4 238 265
- US-A1- 2009 101 195

## Description

### Domaine de l'invention

La présente invention concerne un procédé de mise en forme d'une feuille de matériau ayant une faible résistance à la traction, par exemple du verre, et un miroir comportant une telle feuille.

L'invention concerne également un miroir pour concentrer l'énergie solaire notamment pour être incorporé dans un dispositif pour transformer de l'énergie solaire en énergie thermique ou électrique, notamment en réfléchissant, en concentrant ou focalisant l'énergie solaire à l'aide d'un miroir, comportant une feuille mise en forme par le procédé, vers un collecteur de chaleur ou d'énergie électrique.

Dans le cas d'une utilisation thermique, le procédé décrit dans la présente invention permet la réalisation d'un dispositif, ce dernier permettant de chauffer un fluide caloporteur (eau, eau additivée, huile ou autre) pour des applications variées, par exemple pour alimenter un dispositif de climatisation, pour produire de la chaleur pour l'industrie, l'agroalimentaire, ou autre utilisation directe ou indirecte de la chaleur ainsi produite.

### ARRIERE-PLAN TECHNOLOGIQUE

On connaît plusieurs façons de collecter l'énergie solaire. Une première façon consiste à transformer l'énergie solaire en énergie électrique, notamment à l'aide de cellules photovoltaïques.

Une deuxième façon de collecter l'énergie solaire consiste à transformer l'énergie solaire en énergie thermique, notamment en concentrant ou focalisant l'énergie solaire réfléchie vers un collecteur de chaleur, par exemple à l'aide d'un miroir de forme parabolique ou cylindroparabolique.

La mise en forme du miroir, et le cas échéant de la feuille de verre qu'elle comprend comme élément réflecteur, est problématique.

On connait, ainsi, le brevet Français n°FR2 659 957, déposé le 20 Mars 1990, qui décrit un procédé, représenté en figure 1, pour le bombage sur cadre d'au moins une feuille de verre par gravité. Ce procédé comporte :
une étape 100 d'empilement de la ou des feuilles de verre,
une étape 110 de disposition sur un cadre de bombage en position horizontale,
une étape 120 d'élévation à la température de déformation du verre,
une étape 130 de bombage selon une première forme correspondant à une ébauche de la forme définitive et
une étape 140 de bombage selon la forme définitive.

Néanmoins, lors de l'étape 120, les miroirs sont élevés à la température de déformation du verre à savoir proche 600°C. Ce procédé est donccoûteux en énergie. De plus, les miroirs destinés à collecter de l'énergie solaire sont généralement de grande taille, il s'avère donc que le procédé peut nécessiter des fours de grande taille en adéquation avec la taille du miroir. De tels fours ayant généralement une plus grande inertie thermique que le miroir à mettre en forme, ils nécessitent donc d'autant plus d'énergie de mise en oeuvre notamment aux étapes 130 et 140 du procédé.

Lorsque de tels verres nécessitent d'être contraints par une trempe, du fait des dimensions des feuilles de verre, par exemple de forme cylindroparabolique, ces trempes semblent difficiles à mettre en oeuvre sans risquer de casser un grand nombre de feuilles de verre alors courbées selon le procédé.

Cette mise en forme à chaud doit être effectuée avant l'application du revêtement réfléchissant puisque ce dernier ne supporte généralement pas les températures de déformation du verre. De plus, cette étape d'application du revêtement réfléchissant doit être réalisée sur une forme non plane, ce qui nécessite des outillages spécifiques et génère des coûts importants.

Ces procédés de mise en forme à chaud conduisent à la réalisation de réflecteurs d'épaisseurs importantes (typiquement de 4 à 30 mm) utilisant beaucoup de matière et d'énergie pour leur fabrication. Ces réflecteurs sont donc de poids importants, ce qui les rend inadaptés à des installations hors sol, notamment en toiture de bâtiment. De plus, dans le cas le plus commun où le rayonnement solaire doit traverser la couche de verre pour être réfléchi, l'épaisseur de verre conduit à une perte de rayonnement par absorption, ce qui a pour conséquence une diminution du rendement du réflecteur.

Une autre technique de mise en forme consiste à déformer élastiquement, à température ambiante, une feuille de verre préalablement revêtu d'un revêtement réfléchissant, et maintenir cette forme par une structure porteuse dans cette forme.

Cette technique palie plusieurs des problématiques citées dans de la mise en forme à chaud précédemment décrite.

On connaît les brevets US4238265 *"Method of manufacturing* a *glass parabolic-cylindrical solar collector"*; WO2012/138087 *"Curved laminated panel, preferably parabolic, with a mirror, and process for its manufacturing'* et US4124277 "*Parabolic mirror construction*". Ces inventions permettent de déformer le miroir ou la feuille de verre sans dépasser la limite à rupture du verre.

Dans ce cas, les principaux inconvénients sont :
- la courbure maximale du réflecteur final reste limitée.
- de plus, la limite à rupture du verre suit une loi statistique associée aux paramètres de Weibull, ce qui d'un point de vue industriel sur un grand nombre de pièces augmente le risque de rupture même avec une courbure limitée. et
- la flexion génère des contraintes de traction en surface du verre favorables à l'apparition de fissures lors de la mise en forme ou rendant le produit fragile pendant sa durée de vie.

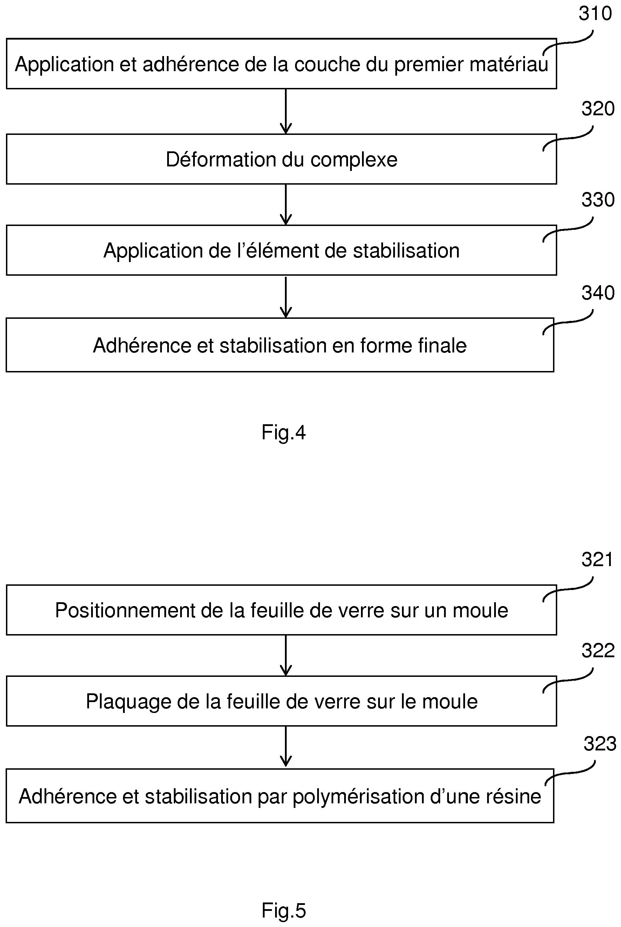

On connaît aussi la demande internationale WO 02/00428. Dans ce document, il est prévu d'effectuer la mise en compression du verre grâce au rétreint de la résine lors de sa polymérisation. Cela nécessite des épaisseurs importantes de résine pour appliquer la contrainte de compression, et l'impossibilité d'utiliser des renforts (fibre ou autre) qui limiteraient ce rétreint. Ce procédé, « facilitant les opérations de manutention de la feuille de verre » ne permet pas non plus d'obtenir des courbures importantes, significativement supérieures à la limite à rupture du verre en flexion (voir Fig.4).

Il est connu de l'homme de l'art la différence de tenue mécanique du verre et des matériaux céramiques entre la tenue en traction et en compression. La résistance en compression de ce type de matériau peut être de 6 à 15 fois supérieure a leur tenue en traction. US-2009101195 concerne un miroir solaire, ii) il enseigne d'utiliser, en sandwich, deux couches de matériau et une feuille et iii) l'une des couches de matériau est du cote convexe de la feuille et donne en traction lors de la déformation de la feuille. GB-2104444 concerne aussi un miroir solaire, mais enseigne d'utiliser une boîte métallique dont le volume est rempli de matériau sous pression.

### BREVE DESCRIPTION DE L'INVENTION

La présente invention vise à remédier à tout ou partie de ces inconvénients.

L'objet de la présente invention consiste en la mise en place d'une précontrainte de compression bi-axiale dans le verre afin de :
- dépasser la limite de déformation initiale du verre afin d'obtenir une courbure significativement plus élevée que dans les inventions précédemment décrites. Cela permet d'obtenir une meilleure focalisation, car l'augmentation de la courbure diminue la sensibilité aux défauts de forme et aux déformations du réflecteur et/ou
- améliorer la robustesse du réflecteur par l'installation des précontraintes de compression comme dans le cas du verre trempé. Une résistance accrue aux agressions (chocs, contraintes extérieures sur le miroir), en obtenant des caractéristiques similaires à du verre trempé.

A cet effet, la présente invention vise, selon un premier aspect, un procédé de mise en forme d'une feuille de verre d'épaisseur Ev. Cette feuille pourra comporter un revêtement réfléchissant. Dans la suite du document, la feuille revêtue ou non d'un revêtement réfléchissant est nommée « feuille de verre ». Ce procédé comporte tout d'abord une étape d'application et d'adhérence sur une première face de la feuille de verre d'une couche d'un premier matériau résistant en traction, ladite couche ayant une épaisseur E1. Il en résulte que sous l'effet d'une sollicitation en flexion, la fibre neutre, dans une section perpendiculaire au plan de la feuille de verre et à l'axe de flexion du complexe formé par la feuille de verre et la couche du premier matériau, se trouve déportée de plus de 20% de l'épaisseur Ev du côté de la couche du premier matériau par rapport à sa position initiale.

Ce premier matériau résistant en traction pourra avoir des caractéristiques orthotropes afin de générer des contraintes de compression biaxiales dans le verre lors de la sollicitation de ce complexe en flexion. L'orientation de ce matériau orthotrope est choisie en fonction de l'axe de courbure.

On pourra adapter les contraintes de compression biaxiales dans le verre en fonction
- des modules d'élasticité du verre et du premier matériau selon la direction de flexion et la direction perpendiculaire.
- des coefficients de poisson, en particulier du premier matériau orthotrope.
- des épaisseurs.
- des rayons de courbure.

Cette étape est suivie d'une étape de déformation du complexe comprenant la feuille de verre revêtue de la couche du premier matériau, dans la forme finale de telle sorte que :
- soit la fibre neutre du complexe est déportée dans le premier matériau. La feuille de verre est alors totalement en compression,
- soit la fibre neutre est déportée vers le premier matériau tout en restant dans la feuille de verre. Le verre est alors sollicité sur une face en compression, et sur l'autre face à un niveau de traction inférieur à la valeur à rupture.

Dans tous les cas, lors de la déformation en flexion de ce complexe (feuille de verre et couche du premier matériau), la contrainte de traction dans la feuille de verre est annulée ou significativement réduite. En raison des écarts des performances mécaniques de la feuille de verre en traction et en compression, cela permet une déformation beaucoup plus importante du complexe que de la feuille de verre seule.

Ce complexe peut alors être courbé jusqu'à la forme définitive souhaitée.

Ce complexe peut être utilisé maintenu à ce niveau de déformation élastique par un dispositif externe ou terminer son processus de mise en forme par les étapes exposées ci-après.

Cette étape consiste en l'application d'une couche d'un deuxième matériau qui conformera le complexe déformé élastiquement dans la position définitive souhaitée. Ce deuxième matériau sera appliqué sur une face libre de la couche du premier matériau opposée à la feuille de verre.

Le procédé objet de l'invention comporte, enfin, une étape d'adhérence de la couche du deuxième matériau sur la couche du premier matériau et de stabilisation dimensionnelle de la forme finale.

Grâce à ces dispositions, le procédé de mise en forme d'une feuille de verre objet de la présente invention permet, à la fois :
- de produire un complexe comportant une feuille de verre, une couche d'un premier matériau adhérente à une première face de la feuille de verre et une couche d'un deuxième matériau adhérente à une face de la couche du premier matériau opposée à la feuille de verre, et
- d'obtenir ledit complexe avec des caractéristiques mécaniques améliorées en termes de résistance mécanique de la feuille de verre, comparables à celles du verre trempé.

Dans des modes de réalisation, le procédé objet de l'invention comporte :
- une étape de positionnement sur un moule de la feuille de verre, revêtue sur sa première face de la couche du premier matériau, une deuxième face de la feuille de verre, opposée à la première face, étant orientée en direction d'une matrice du moule présentant une forme désirée pour la feuille de verre,
- une étape de placage de la feuille de verre sur le moule dans laquelle étape la feuille de verre est amenée au contact de la matrice pour en épouser la forme puis, pendant l'étape d'adhérence de la couche du deuxième matériau sur la couche du premier matériau et de stabilisation dimensionnelle, la feuille de verre est maintenue en contact avec la matrice.

Selon des caractéristiques particulières, la fibre neutre est décalée de telle sorte que la contrainte de traction dans la feuille de verre ne dépasse pas un niveau de contrainte donné pour un rayon de courbure donné (verre coté concave).

Selon des caractéristiques particulières, la fibre neutre est dans la couche du premier matériau.

Selon des caractéristiques particulières, l'étape d'application et d'adhérence sur une première face de la feuille de verre d'une couche d'un premier matériau est effectuée, en maintenant la feuille de verre sensiblement plane ou avec ladite première face concave.

Selon des caractéristiques particulières, l'étape d'application et d'adhérence sur une première face de la feuille de verre d'une couche d'un premier matériau est effectuée, en maintenant la feuille de verre dans une forme permettant l'obtention lors des étapes suivantes des précontraintes de compression souhaitées.

Selon des caractéristiques particulières, la couche du premier matériau pourra présenter des caractéristiques mécaniques orthotropes afin de générer une précontrainte biaxiale dans la feuille de verre.

Grâce à ces dispositions, le procédé de mise en forme d'une feuille de verre objet de la présente invention permet de produire un complexe sensiblement plan avec des modifications de caractéristiques mécaniques.

Selon des caractéristiques particulières, la couche du premier matériau est constituée d'un matériau composite comprenant des fibres minérales ou organiques orientées ou non orientées, tissées ou non tissées, maintenues dans un liant durci, par exemple polymère ou non organique.

Selon des caractéristiques particulières, les fibres minérales sont du type de fibres de verre, les fibres organiques naturelles ou artificielles sont du type aramide et le liant polymère est du type époxy.

Selon des caractéristiques particulières, l'étape d'application et d'adhérence sur la première face de la feuille de verre de la couche du premier matériau est réalisée par l'application de fibres imprégnées d'un liant non durci suivie par une étape de durcissement du liant pendant laquelle la couche du premier matériau est maintenue en contact avec la feuille de verre par application d'une pression.

Selon des caractéristiques particulières, l'étape d'adhérence de la couche du deuxième matériau sur la couche du premier matériau est obtenue par durcissement du liant en contact avec la feuille de verre.

Selon des caractéristiques particulières, l'étape de placage de la feuille de verre sur le moule est effectuée simultanément à une compression de la couche du deuxième matériau sur la couche du premier matériau par la mise en oeuvre d'une vessie placée sur la couche du deuxième matériau et la réalisation d'une dépression ou d'un vide partiel entre la vessie et la matrice du moule, et ou l'application d'une surpression à l'extérieur de la vessie par un autoclave.

Selon des caractéristiques particulières, la forme de la matrice du moule est plane ou convexe de sorte à donner à la deuxième surface de la feuille de verre une forme plane ou concave.

Selon un deuxième aspect, la présente invention vise un miroir comportant une feuille de verre, une couche d'un premier matériau adhérente à une première face de la feuille de verre et une couche d'un deuxième matériau adhérente à une face de la couche du premier matériau opposée à la feuille de verre, dans lequel :
la feuille de verre est principalement sollicitée en compression,
le matériau de la couche de premier matériau est essentiellement sollicité en traction et,
le matériau de la couche de deuxième matériau est sollicité en compression.

Selon des caractéristiques particulières, une forme d'une deuxième face de la feuille de verre, notamment opposé à la première face, est plane ou concave.

Selon des caractéristiques particulières, une forme d'une deuxième face de la feuille de verre, notamment opposé à la première face, est plane ou convexe.

Selon des caractéristiques particulières, ladite première face de la feuille de verre est préalablement revêtue d'un revêtement réfléchissant.

Selon des caractéristiques particulières, ladite deuxième face de la feuille de verre est préalablement revêtue d'un revêtement réfléchissant.

Selon un troisième aspect, la présente invention vise un dispositif pour transformer de l'énergie solaire en énergie thermique ou électrique, notamment en réfléchissant, en concentrant ou focalisant l'énergie solaire à l'aide d'un miroir vers un collecteur de chaleur ou d'énergie électrique. Pour ce faire, le miroir du dispositif objet de l'invention comporte une feuille de verre, une couche d'un premier matériau adhérente à une première face de la feuille de verre et une couche d'un deuxième matériau adhérente à une face libre de la couche du premier matériau, la feuille de verre étant sollicitée en compression, la couche du premier matériau étant sollicitée en traction et la couche du deuxième matériau étant sollicitée en compression.

### BREVE DESCRIPTION DES DESSINS

D'autres avantages, buts et caractéristiques particulières de la présente invention ressortiront de la description qui va suivre faite, dans un but explicatif et nullement limitatif, en regard des dessins annexés, dans lesquels :

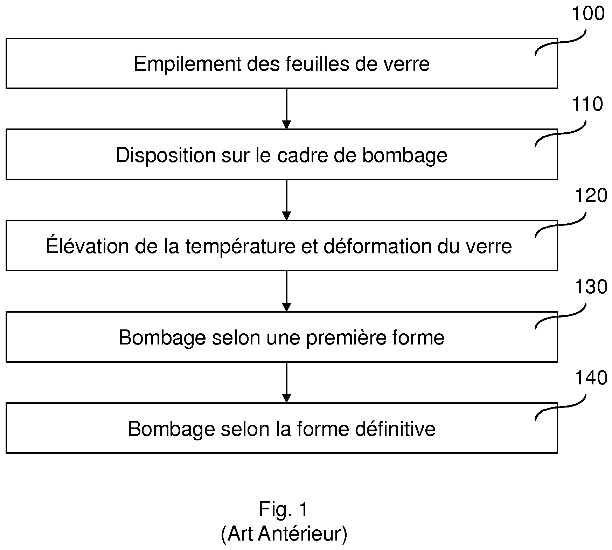

- la figure 1 représente sous forme de logigramme, des étapes mises en œuvre connues pour le bombage de feuilles de verre,
- la figure 2 représente une vue en coupe, section perpendiculaire à un plan de la feuille de verre du miroir objet de l'invention,
- la figure 3 représente une vue partielle éclatée du miroir objet de l'invention, suivant une réalisation d'un prototype ayant donné satisfaction,
- la figure 4 représente, sous forme de logigramme, des étapes mises en œuvre dans un mode de réalisation particulier du procédé objet de la présente invention,
- la figure 5 représente, sous forme de logigramme, des étapes mises en œuvre dans un mode de réalisation particulier du procédé objet de la présente invention,
- la figure 6 représente, sous forme de logigramme, des étapes mises en œuvre dans un mode de réalisation particulier du procédé objet de la présente invention et
- la figure 7 représente, sous forme de logigramme, des étapes mises en œuvre dans un mode de réalisation particulier du procédé objet de la présente invention.

### DESCRIPTION DETAILLEE DE MODES DE REALISATION DE L'INVENTION

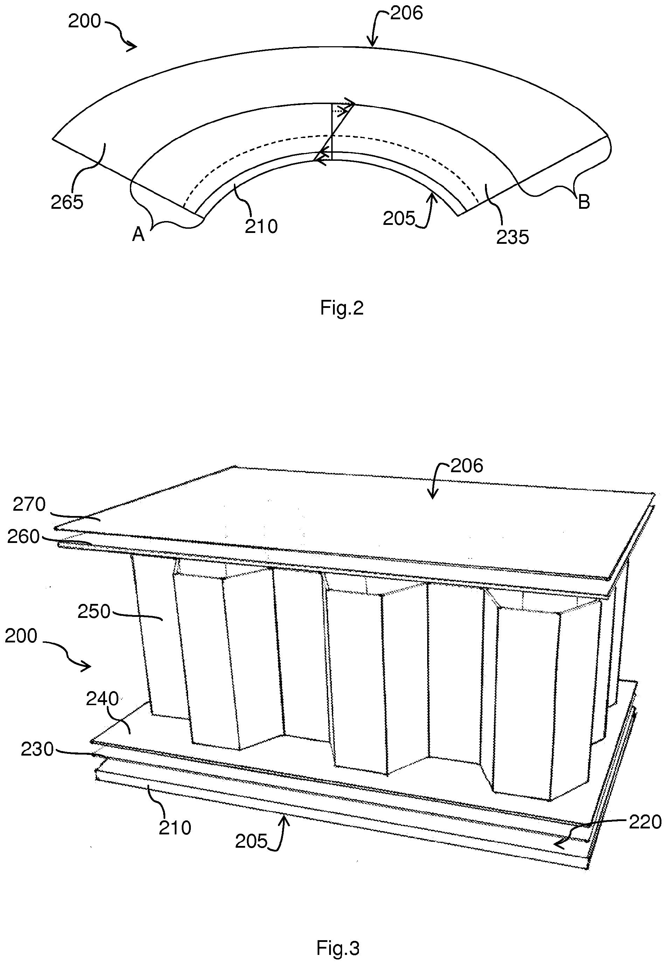

On note à la figure 2 et à la figure 3 que les différents composants du miroir ne sont pas représentés à l'échelle. En effet, une courbure de la figure 2 est exagérée afin de mettre en évidence des phénomènes physiques et les épaisseurs des différentes couches ne sont pas à l'échelle. De plus, seule une petite partie du miroir de la figure 3 est représentée plane pour en faciliter la compréhension.

Ainsi, à la figure 2, on peut voir un miroir 200 objet de l'invention comprenant, un assemblage de matériaux en couches successives depuis une face avant 205 du miroir vers une face arrière 206 du miroir. Le complexe A est constitué : d'une feuille de verre, éventuellement revêtue d'un traitement réfléchissant et d'une couche d'un premier matériau. L'élément B est un élément permettant de stabiliser A dans la forme souhaitée.

L'élément réfléchissant A comprend lui-même une feuille de verre 210 réfléchissante, sur une face arrière de laquelle est fixée une couche avant d'un matériau structural 235.

La caractéristique réfléchissante de l'élément A provient des propriétés de la feuille de verre 210 qui peut en outre comporter un revêtement réfléchissant sur l'une de ses deux faces.

Il est également représenté à la figure 2 des efforts de cisaillement auxquels l'élément A est soumis, la ligne en pointillé représentant une fibre neutre (ou ligne neutre) desdits efforts de cisaillement :
- la feuille de verre 210 présente la caractéristique d'être principalement sollicitée en compression,
- la couche avant 235 de matériau structural présente la caractéristique d'être essentiellement sollicitée en traction,
- la fibre neutre se trouve déportée à l'intérieur de la couche avant 235 de matériau structural ou à l'interface entre la couche avant 235 et la feuille de verre 210.

Dans une forme de réalisation préférée, la couche avant 235 de matériau structural est d'une épaisseur suffisante pour que la fibre neutre de cisaillement au sein de l'élément réfléchissant A soit déportée dans la couche 235 de matériau structural et que la feuille de verre se trouve sollicitée en compression totalement ou dans la plus grande partie de son épaisseur.

Dans une forme de réalisation, la couche 235 de matériau structural comporte au moins une couche d'un matériau composite, ou pli, mettant en œuvre des fibres organiques ou minérales (par exemple, aramide, verre, carbone, maintenue dans un liant à l'état durci. Par exemple, le matériau comporte au moins un tissu ou au moins un mat de fibres organiques ou minérales.

L'élément de stabilisation B associé à l'élément réfléchissant A présente une rigidité suffisante pour garantir la stabilité de forme du miroir. Pour cela, l'élément de stabilisation B est sollicité en compression de sorte que la couche 235 de matériau structural est essentiellement sollicité en en traction.

Du fait que l'élément réfléchissant A est maintenu par la couche avant de matériau structural 235 en compression, alors l'élément de stabilisation B est lui-même sollicité en compression.

L'élément de stabilisation B comprend, donc, en lui-même au moins un matériau, ayant des caractéristiques mécaniques suffisantes pour maintenir la couche 235 de matériau structural principalement dans une sollicitation en traction.

Dans une forme de réalisation, l'élément B comporte au moins une couche 265 de matériau structural d'un matériau composite mettant en œuvre un renfort, par exemple des fibres organiques ou minérales (par exemple aramide, verre, carbone) maintenue dans une matrice, par exemple un liant à l'état durci. Par exemple, le matériau comporte au moins un tissu ou au moins un mat de fibres organiques ou minérales.

Dans une forme de réalisation, l'élément B comporte en outre un matériau d'âme :
- de faible densité par rapport aux couches 265 et couche 235 de matériau structural, et
- aux caractéristiques mécaniques faibles devant celles des couches 265 et couche 235 de matériau structural. Ce matériau pourra être un matériau alvéolaire de type « nid d'abeille »
de telle sorte que lesdites couches et le matériau d'âme forment une structure en sandwich. Cette structure à sandwich peut présenter la caractéristique d'être symétrique ou asymétrique.

Dans une forme de réalisation, le matériau d'âme est une mousse. Dans une forme de réalisation, le matériau d'âme est une structure alvéolaire.

Suivant une réalisation d'un prototype ayant donné satisfaction, dont seule une petite partie est représenté en vue éclatée plane à la figure 3, le miroir 200 comporte l'assemblage de matériaux en couches successives depuis la face avant 205 du miroir vers la face arrière 206 du miroir. On y observe la feuille de verre 210, revêtue d'un revêtement réfléchissant 220 sur une face de la feuille de verre 210, un premier tissu de fibre de verre 230, un premier mat de verre 240, une structure alvéolaire 250, un deuxième mat de verre 260 et un deuxième tissu de verre 270.

Les couches successives ci-dessus sont assemblées par un liant organique durci.

La feuille de verre 210, revêtue ou non d'un revêtement réfléchissant 220 sur une face de la feuille de verre 210, le premier tissu de fibre de verre 230 et le premier mat de verre 240 forment l'élément réfléchissant A, la couche avant 235 de matériau structural étant composée du premier tissu de verre 230 et du premier mat de verre 240.

La structure alvéolaire 250, le deuxième mat de verre 260 et le deuxième tissu de verre 270 forment l'élément de stabilisation B, la couche 265 de matériau structural étant composée du deuxième mat de verre 260 et du deuxième tissu de verre 270

Dans des formes de réalisation de prototypes ayant donnée satisfaction, les tissus de fibres de verre 230 et 270, ainsi que les mats de verre 240 et 260, ont des masses surfaciques comprises entre 250 g/m² et 350g/m². Des épaisseurs Ev de la feuille de verre 210 sont comprises entre 0,1 mm et 10 mm. Des épaisseurs du nid d'abeille 250 sont comprises entre 2 mm et 200 mm. Préférentiellement, l'épaisseur du nid d'abeille 250 est comprise entre 5 mm et 45 mm. Plus préférentiellement, l'épaisseur du nid d'abeille 250 est comprise entre 20 mm et 30 mm. Par exemple, un rayon de courbure inférieur à 50 cm pour une épaisseur supérieure ou égale à 1 mm. L'homme du métier pourra cependant sortir de ces valeurs en fonction des tailles de miroirs.

L'invention concerne également un procédé de mise en forme d'une feuille de verre, tel que représenté en figure 4, une forme initiale de la feuille de verre étant différente d'une forme finale de ladite feuille de verre. Le procédé est particulièrement bien adapté à la réalisation du miroir 200.

Le procédé comporte :
- une étape 310 d'application et d'adhérence sur une première face de la feuille de verre d'une couche d'un premier matériau apte à résister à des contraintes de traction, ladite couche ayant une épaisseur E1 de telle sorte que lors d'une sollicitation en flexion, une fibre neutre, dans une section perpendiculaire à un plan de la feuille de verre, du complexe formé par la feuille de verre et la couche du premier matériau se trouve déportée du côté de la couche du premier matériau, la feuille de verre étant dans une forme initiale.

Autrement dit, au cours de l'étape 310 d'application et d'adhérence sur une première face de la feuille de verre d'une couche d'un premier matériau, le complexe A est fabriqué.

Dans une réalisation particulière, cette étape d'adhérence peut consister à la polymérisation d'une résine polymère.

Dans une réalisation particulière, cette étape peut être réalisée à l'aide d'une vessie, d'une mise sous vide et de l'application d'une pression par la pression atmosphérique ou un autoclave.

Dans une réalisation particulière, cette étape pourra être réalisée sur un moule de forme plane, convexe, concave ou toute autre forme plus complexe, afin de générer les contraintes de compression dans la feuille de verre au niveau souhaité. - une étape 320 qui consiste à déformer le complexe A vers une forme proche de la forme finale que l'on souhaite obtenir.

Dans une forme de réalisation, le complexe A pourra être conformé en utilisant un moule.

Dans une forme de réalisation, on pourra utiliser un dispositif à dépression pour conformer le complexe A sur le moule.
- une étape 330 qui consiste en l'application de l'élément de stabilisation B dans l'objectif de stabiliser le complexe A et d'obtenir la forme finale. Ce deuxième matériau est apte à résister à des contraintes de compression sur une face libre de la couche du premier matériau opposée à la feuille de verre.

Dans une forme de réalisation, on pourra utiliser un ensemble de couches de matériaux composite, notamment mousse, nid d'abeille, renfort de tissu, mat, résine ou autre.

Dans une forme de réalisation, l'élément de stabilisation B pourra être une structure porteuse maintenant le complexe A dans la position souhaitée. - une étape 340 d'adhérence de l'élément de stabilisation B sur la couche du complexe A et de stabilisation dimensionnelle de la forme finale.

Autrement dit, au cours de l'étape 340 d'adhérence de l'élément de stabilisation B sur le complexe A et de stabilisation dimensionnelle de la forme finale, l'élément de stabilisation passe à l'état durci en absence de contrainte externe dans la forme finale, ce qui lui permet de maintenir le complexe en forme finale.

Dans une forme de réalisation particulière, cette étape pourra être réalisée par application d'un dispositif de dépression, par exemple une vessie, drain, tissu à délaminer, autoclave, peau de matage ou contre moule.

Dans des formes de réalisation de prototypes ayant donné satisfaction, l'étape 320 de mise en forme du complexe comprenant la feuille de verre revêtue de la première couche de matériau et de la couche de deuxième matériau, comporte des sous-étapes illustrées en figure 5 :
- une étape 321 de positionnement sur un moule de la feuille de verre 210, revêtue sur sa première face de la couche du premier matériau, une deuxième face de la feuille de verre, opposée à la première face, étant orientée en direction d'une matrice du moule présentant une forme désirée pour la feuille de verre,
- une étape 322 de placage de la feuille de verre 210 sur le moule, de telle sorte que la feuille de verre 210 est amenée au contact de la matrice pour en épouser la forme et
- une étape 323 d'adhérence et de stabilisation de la forme finale par polymérisation d'une résine organique.

Dans un mode de réalisation particulier, le complexe A et l'élément de stabilisation B peuvent être maintenus en position par un dispositif comprenant un moule et un contre moule.

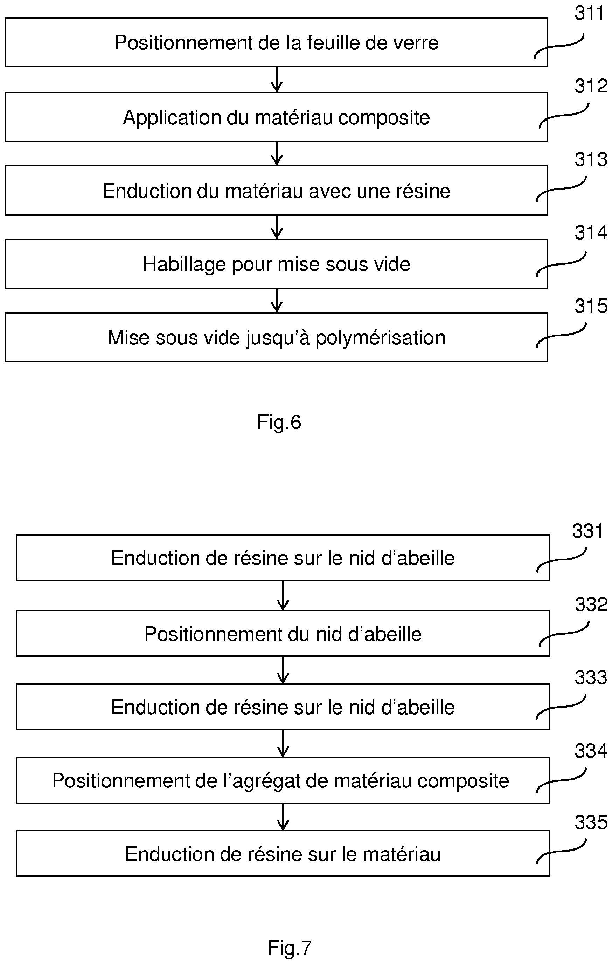

Dans des formes de réalisation du procédé ayant donnée satisfaction, l'étape 310 d'application et d'adhérence sur la première face de la feuille de verre 210 de la couche de premier matériau comprend en elle-même, telle que représentée à la figure 6 :
- une étape 311 de positionnement de la feuille de verre 210 sur une matrice d'un premier moule, la matrice de moule étant sensiblement plane, concave, convexe ou de forme complexe
- une étape 312 d'application du matériau composite de la couche avant 235 de matériau structural sur la surface libre de la feuille de verre 210, par exemple, en appliquant un tissu sec et un mat sec à imprégner d'un liant ou en appliquant un tissu pré-imprégné de liant ou une projection de liant et de renfort selon des méthodes d'imprégnation connues de l'homme du métier,
- une étape 313 d'adhérence du matériau composite
- une étape 314 d'habillage pour mise sous vide et
- une étape 315 de mise sous vide jusqu'à polymérisation du liant polymère.

Au cours de l'étape 312 d'application du matériau composite, l'application du matériau composite est réalisée de telle sorte que toute la surface de la feuille de verre soit recouverte par ledit matériau. Dans une forme de réalisation, le matériau composite est composé d'au moins un pli mettant en œuvre des fibres organiques ou minérales (par exemple, aramide, verre, carbone, ...). Suivant un mode de réalisation, les plis sont appliqués pré-imprégnés sur la feuille de verre. Suivant un mode de réalisation, les plis sont appliqués sur la feuille de verre secs puis imprégnés d'une résine polymérisable. Le cas échéant la surface libre de la feuille de verre 210, est préalablement enduite de résine de la feuille de verre 210.

L'étape d'imprégnation est connue de l'homme du métier.

Le nombre de plis est avantageusement choisi en fonction de l'épaisseur souhaitée de la couche 235. Par exemple, pour une feuille de verre de un mm d'épaisseur, un tissu de un mm d'épaisseur et un mat de 0,5 mm d'épaisseur permet de le réaliser.

L'étape 311 de positionnement sur le moule de la feuille, revêtue sur sa première face de la couche du premier matériau, est notamment réalisée de telle sorte que ladite deuxième face de la feuille de verre, opposée à la première face, est orientée en direction de ladite matrice du moule. La forme de la matrice du moule est plane ou convexe de telle sorte que ladite deuxième face de la feuille de verre a une forme plane ou concave.

Dans une réalisation préférée, l'élément de stabilisation B comprend une structure alvéolaire du type nid d'abeille, au moins un agrégat mettant en œuvre des fibres organiques ou minérales (par exemple, aramide, verre, carbone, ...), ledit agrégat étant tissé ou non.

Ainsi, dans une réalisation préférée, l'étape 330 d'application et l'étape 340 d'adhérence de l'élément de stabilisation B sur le complexe A comprennent en elles-mêmes, comme représentée à la figure 7 :
- une étape 331 d'enduction de résine sur le nid d'abeille,
- une étape 332 de positionnement du nid d'abeille sur une face libre de la couche du premier matériau de l'élément réfléchissant A, une face enduite du nid d'abeille étant en positionnée en contact avec ladite face libre de la couche de premier matériau,
- une étape 333 d'enduction de résine sur le nid d'abeille, notamment sur une deuxième face dudit nid d'abeille,
- une étape 334 de positionnement de l'agrégat de matériau composite sur le nid d'abeille et
- une étape 335 d'enduction de résine de l'agrégat de matériau composite.

Les étapes 332, 333 et 334 construisent l'élément de stabilisation B.

## Revendications

1. Procédé de mise en forme d'une feuille de verre (210), d'épaisseur Ev, qui comporte :
une étape (310) d'application et d'adhérence sur une première face de la feuille (210) d'une couche d'un premier matériau (235) résistant à des contraintes de traction supérieures à celles de ladite feuille, ladite couche ayant une épaisseur E1, de telle sorte que lors d'une sollicitation en flexion de ce complexe, la fibre neutre se trouve déportée de plus de 20 % de l'épaisseur Ev de la feuille,
**caractérisé en ce qu'**il comporte, de plus :
une étape (320) de déformation élastique du complexe comprenant la feuille (210) revêtue de la première couche de matériau (235) dans la forme finale, de telle sorte que la feuille soit principalement sollicitée en compression par rapport à la forme initiale du fait du déport de la fibre neutre,
une étape (330) d'application sans contrainte d'une couche d'un deuxième matériau (265) résistant à des contraintes de compression, sur une face libre de la couche du premier matériau (235) opposée à la feuille (210), la couche du deuxième matériau (265) épousant une forme finale de ladite face de la couche de premier matériau, la couche de deuxième matériau conformant le complexe dans la forme finale,
une étape (340) d'adhérence de la couche du deuxième matériau (265) sur la couche du premier matériau (235) et de stabilisation dimensionnelle de la forme finale et
une étape de relâchement au cours de laquelle :
- la couche de deuxième matériau maintient la couche de premier matériau (235) dans une sollicitation en traction,
- un matériau constitutif de la feuille (210) est principalement sollicité en compression et
- le matériau de la couche de deuxième matériau (265) est sollicité en compression.

2. Procédé selon la revendication 1, dans lequel l'étape (320) de déformation élastique comporte :
une étape (311) de positionnement de la feuille (210) sur un moule présentant une forme désirée pour la feuille, la feuille étant revêtue sur sa première face de la couche du premier matériau (235), une deuxième face de la feuille, opposée à la première face, étant orientée en direction d'une matrice du moule,
une étape (312) de placage de la feuille sur le moule dans laquelle la feuille est amenée au contact de la matrice pour en épouser la forme,
le maintien de la feuille plaquée sur le moule se poursuivant pendant l'application et l'adhérence de la couche du deuxième matériau sur la couche du premier matériau et de stabilisation dimensionnelle.

3. Procédé selon la revendication 2, dans lequel l'étape de placage de la feuille sur le moule est effectuée simultanément à une compression de la couche du deuxième matériau sur la couche du premier matériau par la mise en œuvre d'une vessie placée sur la couche du deuxième matériau et la réalisation d'une dépression ou d'un vide partiel entre la vessie et la matrice du moule, et ou l'application d'une surpression à l'extérieur de la vessie par un autoclave.

4. Procédé selon l'une des revendications 1 à 3, dans lequel l'étape (310) d'application et d'adhérence sur une première face de la feuille d'une couche d'un premier matériau est effectuée en maintenant la feuille (210) sensiblement plane ou avec ladite première face concave.

5. Procédé selon l'une des revendications 1 à 4, dans lequel, au cours de l'étape (320) de déformation élastique, la fibre neutre est déportée dans la couche du premier matériau, le matériau de la feuille étant alors intégralement en compression.

6. Procédé selon l'une des revendications 1 à 5, dans lequel la couche du premier matériau présente des caractéristiques mécaniques orthotropes générant une précontrainte biaxiale dans la feuille.

7. Procédé selon l'une des revendications 1 à 6, dans lequel la couche du premier matériau est constituée d'un matériau composite comprenant des fibres minérales ou organiques orientées ou non orientées, tissées ou non tissées, maintenues dans un liant durci, par exemple polymère ou non organique.

8. Procédé selon l'une des revendications 1 à 7, dans lequel l'étape (310) d'application et d'adhérence sur la première face de la feuille (210) de la couche du premier matériau est réalisé par l'application de fibres imprégnées d'une résine non durcie suivie par une étape de durcissement de la résine pendant laquelle la couche du premier matériau (235) est maintenue en contact avec la feuille par application d'une pression.

9. Procédé selon l'une des revendications 7 ou 8, dans lequel la couche du premier matériau est constituée de fibres minérales du type de fibres de verre ou de fibres organiques naturelles ou artificielles, du type aramide et d'un liant polymère du type époxy.

10. Procédé selon l'une des revendications 1 à 9, dans lequel l'étape (340) d'adhérence de la couche du deuxième matériau (265) sur la couche du premier matériau (235) et de stabilisation dimensionnelle de la forme finale est effectuée par durcissement d'un liant entre la couche de deuxième matériau et la couche de premier matériau.

11. Procédé selon l'une des revendications 1 à 10, dans lequel la couche du deuxième matériau (265) est constituée d'un matériau composite comprenant des fibres minérales ou organiques orientée ou non, tissées ou non, et dans une résine dure.

12. Procédé selon la revendication 11, dans lequel l'étape (340) d'adhérence de la couche du deuxième matériau sur la couche du premier matériau est obtenue par durcissement de la résine comprimée et durcie en contact avec la couche de premier matériau.

13. Miroir obtenu par le procédé selon la revendication 1 comportant une feuille de verre (210), une couche d'un premier matériau (235) adhérente à une première face de la feuille (210) et une couche d'un deuxième matériau (265) adhérente à une face de la couche du premier matériau (235) opposée à la feuille (210), **caractérisé en ce que** :
le verre constitutif de la feuille (210) est principalement sollicité en compression,
le matériau de la couche de premier matériau (235) est essentiellement sollicité en traction et,
le matériau de la couche de deuxième matériau (265) est sollicité en compression.

14. Miroir selon la revendication 13, dans lequel ladite première face de la feuille et/ou adite deuxième face de la feuille est revêtue d'un revêtement réfléchissant.

15. Dispositif pour transformer de l'énergie solaire en énergie thermique ou électrique, notamment en réfléchissant, en concentrant ou focalisant l'énergie solaire à l'aide d'un miroir selon l'une des revendications 13 ou 14 vers un collecteur de chaleur ou d'énergie électrique.

## Patentansprüche

1. Formgebungsverfahren einer Glasfolie (210) einer Dicke Ev, die umfasst:
einen Anwendungs- und Anhaftungsschritt (310) auf einer ersten Seite der Folie (210) einer Schicht eines ersten Materials (235), das Zugbeanspruchungen widersteht, die größer sind als die der genannten Folie, wobei die genannte Schicht eine Dicke E1 derart aufweist, dass die neutrale Faser bei einer Biegungsbeanspruchung dieses Komplexes um mehr als 20 % der Dicke Ev der Folie versetzt wird,
**dadurch gekennzeichnet, dass** es darüber hinaus umfasst:
einen elastischen Verformungsschritt (320) des Komplexes, umfassend die mit der ersten Materialschicht (235) beschichtete n Folie 210) in der endgültigen Form derart, dass die Folie aufgrund der Versetzung der neutralen Faser im Verhältnis zur ursprünglichen Form hauptsächlich in Komprimierung angesprochen wird,
einen Anwendungsschritt (320) ohne Beanspruchung einer Schicht eines zweiten Materials (265), das Komprimierungsbeanspruchungen auf einer freien Seite der Schicht des ersten Materials (235) gegenüber der Folie (210) widersteht, wobei die Schicht des zweiten Materials (265) eine endgültige Form der genannten Seite der Schicht aus erstem Material annimmt, wobei die Schicht aus zweitem Material den Komplex in der endgültigen Form annimmt,
einen Anhaftungsschritt (340) der Schicht des zweiten Materials (265) auf der Schicht des ersten Materials (235) und Abmessungsstabilisierung der endgültigen Form und
einen Lockerungsschritt, in dessen Verlauf:
- die Schicht aus zweitem Material die Schicht aus erstem Material (235) in einer Zugbeanspruchung hält,
- ein die Folie (210) bildendes Material hauptsächlich in Komprimierung angesprochen wird und
- das Material der Schicht aus zweitem Material (265) in Komprimierung angesprochen wird.

2. Verfahren gemäß Anspruch 1, bei dem der elastische Verformungsschritt (320) umfasst:
einen Positionierungsschritt (311) der Folie (210) auf einer Form, die eine für die Folie gewünschte Form aufweist, wobei die Folie auf ihrer ersten Seite der Schicht des ersten Materials (235) beschichtet wird, wobei eine zweite Seite der Folie gegenüber der ersten Seite in Richtung einer Matrix der Form ausgerichtet wird,
einen Plattierungsschritt (312) der Folie auf der Form, in dem die Folie mit der Matrix in Kontakt gebracht wird, um die Form anzunehmen,
das Halten der plattierten Folie auf der Form während der Anwendung und der Anhaftung der Schicht des zweiten Materials auf der Schicht des ersten Materials und der Abmessungsstabilisierung fortgesetzt wird.

3. Verfahren gemäß Anspruch 2, bei dem der Plattierungsschritt der Folie auf der Form gleichzeitig mit einem Komprimieren der Schicht des zweiten Materials auf der Schicht des ersten Materials durch das Umsetzen einer auf der Schicht des zweiten Materials angeordneten Blase und die Realisierung eines Unterdrucks oder eines Teilvakuums zwischen der Blase und der Matrix der Form und oder die Anwendung eines Überdrucks außerhalb der Blase durch einen Autoklav durchgeführt wird.

4. Verfahren gemäß einem der Ansprüche 1 bis 3, bei dem der Anwendungs- und Anhaftungsschritt (310) auf einer ersten Seite der Folie einer Schicht eines ersten Materials durch Halten der Folie (210) deutlich eben oder mit der genannten ersten konkaven Seite durchgeführt wird.

5. Verfahren gemäß einem der Ansprüche 1 bis 4, bei dem im Verlauf des elastischen Verformungsschritts (320) die neutrale Faser in die Schicht des ersten Materials versetzt wird, wobei das Material der Folie dann vollumfänglich in Komprimierung ist.

6. Verfahren gemäß einem der Ansprüche 1 bis 5, bei dem die Schicht des ersten Materials orthotrope, mechanische Merkmale aufweist, die eine biaxiale Vorspannung in der Folie erzeugen.

7. Verfahren gemäß einem der Ansprüche 1 bis 6, bei dem die Schicht des ersten Materials aus einem Verbundmaterial gebildet wird, umfassend mineralische oder organische Fasern, die ausgerichtet oder nicht ausgerichtet, gewebt oder nicht gewebt, in einem ausgehärteten Bindemittel, z. B. Polymer oder nicht organisch, gehalten werden.

8. Verfahren gemäß einem der Ansprüche 1 bis 7, bei dem der Anwendungs- und Anhaftungsschritt (310) auf der ersten Seite der Folie (210) der Schicht des ersten Materials durch die Anwendung von mit einem nicht ausgehärteten Harz imprägnierten Fasern, gefolgt von einem Härtungsschritt des Harzes realisiert wird, bei dem die Schicht des ersten Materials (235) mit der Folie per Anwendung eines Druck in Kontakt gehalten wird.

9. Verfahren gemäß einem der Ansprüche 7 oder 8, bei dem die Schicht des ersten Materials aus mineralischen Fasern vom Typ Glasfasern oder natürlichen oder künstlichen organischen Fasern vom Typ Aramid und einem Polymer-Bindemittel vom Typ Epoxyd gebildet wird.

10. Verfahren gemäß einem der Ansprüche 1 bis 9, bei dem der Anhaftungsschritt (340) der Schicht des zweiten Materials (265) auf der Schicht des ersten Materials (235) und der Abmessungsstabilisierung der endgültigen Form per Aushärten eines Bindemittels zwischen der Schicht aus zweitem Material und der Schicht aus erstem Material durchgeführt wird.

11. Verfahren gemäß einem der Ansprüche 1 bis 10, bei dem die Schicht des zweiten Materials (265) aus einem Verbundmaterial, umfassend mineralische oder organische Fasern, die ausgerichtet oder nicht ausgerichtet, gewebt oder nicht gewebt und in einem ausgehärteten Harz sind, gebildet wird.

12. Verfahren gemäß Anspruch 11, bei dem der Anhaftungsschritt (340) der Schicht des zweiten Materials auf der Schicht des ersten Materials per Aushärten des komprimierten und gehärteten Harzes in Kontakt mit der Schicht aus erstem Material durchgeführt wird.

13. Spiegel, der durch das Verfahren gemäß Anspruch 1 erhalten wird, umfassend eine Glasfolie (210), eine Schicht aus einem an einer ersten Seite der Folie (210) anhaftenden ersten Material (235) und eine Schicht aus einem an einer Seite der Schicht des ersten Materials (235) anhaftenden zweiten Material (265) gegenüber der Folie (210), **dadurch gekennzeichnet, dass**:
das die Folie (210) bildende Glas hauptsächlich in Komprimierung angesprochen wird,
das Material der Schicht aus erstem Material (235) im Wesentlichen in Zug angesprochen wird und
das Material der Schicht aus zweitem Material (265) in Komprimierung angesprochen wird.

14. Spiegel gemäß Anspruch 13, bei dem die genannte erste Seite der Folie und / oder die genannte zweite Seite der Folie mit einer reflektierenden Beschichtung beschichtet wird.

15. Vorrichtung zum Umformen von Sonnenenergie in Wärme- oder elektrische Energie, insbesondere durch Reflektieren, Konzentrieren oder Fokussieren von Sonnenenergie mithilfe eines Spiegels gemäß einem der Ansprüche 13 oder 14 zu einem Kollektor für Wärme oder elektrische Energie.

## Claims

1. Method for shaping a glass sheet (210) having a thickness Ev, comprising:
a step (310) of applying and adhering onto a first surface of the sheet (210) a layer of a first material (235) withstanding higher tensile stresses than those of said sheet, said layer having a thickness E1 such that, when this complex is subjected to bending, the neutral fiber is moved by more than 20% of the sheet's thickness Ev;
**characterized in that** it also comprises:
a step (320) of elastically deforming the complex comprising the sheet (210) coated with the first layer of material (235) into the final shape, such that the sheet is principally subjected to compression relative to the initial shape because of the neutral fiber having moved;
a step (330) of applying a layer of a second material (265), resistant to compression stresses, on a free surface of the layer of the first material (235) opposite to the sheet (210), the layer of the second material (265) adopting a final shape of said surface of the layer of first material, the layer of second material shaping the complex into the final shape;
a step (340) of adhering the layer of the second material (265) onto the layer of the first material (235) and of dimensionally stabilizing the final shape; and
a release step, during which:
- the layer of second material keeps the layer of first material (235) subjected to traction,
- a constitutive material of the sheet (210) is principally subjected to compression; and
- the material of the layer of second material (265) is subjected to compression.

2. Method according to claim 1, wherein the elastic deformation step (320) comprises:
a step (311) of positioning the sheet (210) on a mold having a required shape for the sheet, the sheet being coated on its first surface with the layer of the first material (235), a second surface of the sheet, opposite the first surface, being oriented in the direction of a die of the mold;
a step (312) of pushing the sheet tight against the mold, wherein the sheet is brought into contact with the die to adopt its shape,
the sheet being kept pushed tight against the mold continues during the application and adherence of the layer of the second material onto the layer of the first material and dimensional stabilization.

3. Method according to claim 2, wherein the step of pushing the sheet tight against the mold is performed simultaneously with a compression of the layer of the second material on the layer of the first material by utilizing a bladder placed on the layer of the second material and producing low pressure or partial vacuum between the bladder and the die of the mold, and/or by application of overpressure outside the bladder by an autoclave.

4. Method according to one of claims 1 to 3, wherein the step (310) of applying and adhering a layer of a first material onto a first surface of the sheet is performed while keeping the sheet (210) substantially flat or with said first surface being concave.

5. Method according to one of claims 1 to 4, wherein, during the elastic deformation step (320), the neutral fiber moves across into the layer of the first material, the material of the sheet then being fully compressed.

6. Method according to one of claims 1 to 5, wherein the layer of the first material has orthotropic mechanical characteristics generating a biaxial prestress in the sheet.

7. Method according to one of claims 1 to 6, wherein the layer of the first material is made of a composite material comprising mineral or organic fibers, oriented or not, woven or non-woven, maintained in a cured binder, for example polymer or non-organic.

8. Method according to one of claims 1 to 7, wherein the step (310) of applying and adhering the layer of the first material onto the first surface of the sheet (210) is performed by applying fibers impregnated with an uncured resin followed by a step of curing the resin during which the layer of the first material (235) is maintained in contact with the sheet by applying pressure.

9. Method according to one of claims 7 or 8, wherein the layer of the first material is made of glass-fiber-type mineral fibers, or aramid-type natural or artificial organic fibers, and an epoxy-type polymer binder.

10. Method according to one of claims 1 to 9, wherein the step (340) of adhering the layer of the second material (265) onto the layer of the first material (235) and of dimensionally stabilizing the final shape is performed by curing a binder between the layer of second material and the layer of first material.

11. Method according to one of claims 1 to 10, wherein the layer of the second material (265) is made of a composite material comprising mineral or organic fibers, oriented or not, woven or non-woven, in a cured resin.

12. Method according to claim 11, wherein the step (340) of adhering the layer of the second material onto the layer of the first material is achieved by curing the compressed cured resin in contact with the layer of the first material.

13. Mirror obtained by the method according to claim 1 comprising a sheet (210), a layer of a first material (235) adhering to a first surface of the sheet (210) and a layer of a second material (265) adhering to a surface of the layer of the first material (235) opposite to the sheet (210), **characterized in that**:
the glass forming the sheet (210) is principally subjected to compression;
the material of the layer of first material (235) is mainly subjected to traction; and
the material of the layer of second material (265) is subjected to compression.

14. Mirror according to claim 13, wherein said first surface of the sheet and/or said second surface of the sheet is coated with a reflective coating.

15. Device for transforming solar energy into thermal or electrical energy, in particular by reflecting, concentrating or focusing solar energy by means of a mirror according to one of claims 13 or 14, towards a collector of heat or electrical energy.
